(19) Europäisches Patentamt
European Patent Office
Office européen des brevets

(11) **EP 4 459 300 B1**

(12) **EUROPEAN PATENT SPECIFICATION**

(45) Date of publication and mention
of the grant of the patent:
**11.03.2026  Bulletin 2026/11**

(21) Application number: **22914383.9**

(22) Date of filing: **20.12.2022**

(51) International Patent Classification (IPC):
**G01R 31/387** *(2019.01)*     **G01R 31/36** *(2020.01)*
**G01R 31/3832** *(2019.01)*

(52) Cooperative Patent Classification (CPC):
**G01R 31/387; G01R 31/3832;** G01R 31/367;
Y02T 10/70

(86) International application number:
**PCT/CN2022/140239**

(87) International publication number:
**WO 2023/125129 (06.07.2023 Gazette 2023/27)**

(54) **METHOD FOR ESTIMATING SOC OF BATTERY, AND RELATED APPARATUS**

VERFAHREN ZUR SCHÄTZUNG DES LADESTATUS EINER BATTERIE UND ZUGEHÖRIGE VORRICHTUNG

PROCÉDÉ D'ESTIMATION DE L'EDC D'UNE BATTERIE ET APPAREIL ASSOCIÉ

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**

(30) Priority: **28.12.2021  CN 202111627071**

(43) Date of publication of application:
**06.11.2024  Bulletin 2024/45**

(73) Proprietor: **Great Wall Motor Company Limited
Baoding, Hebei 071000 (CN)**

(72) Inventors:
• **ZHANG, Junwei
Baoding, Hebei 071000 (CN)**
• **KANG, Wenrong
Baoding, Hebei 071000 (CN)**

(74) Representative: **Klunker IP
Patentanwälte PartG mbB
Destouchesstraße 68
80796 München (DE)**

(56) References cited:
WO-A1-03/107470         CN-A- 107 991 623
CN-A- 109 725 258       CN-A- 110 673 040
CN-A- 110 673 040       CN-A- 112 415 410
CN-A- 112 415 411       CN-A- 112 540 313
CN-A- 115 113 072       JP-A- 2016 166 817

**Description**

TECHNICAL FIELD

The present invention relates to the field of battery technologies, and more particularly, to a method for estimating an SOC of a battery, and a related apparatus.

BACKGROUND

In a battery management system, a state of charge (SOC) of a battery is a very important battery parameter. The SOC represents a percentage of the remaining charge capacity of a battery pack to a battery capacity, and is used for evaluating the current remaining available capacity of the battery pack. Accurate estimation of the SOC may ensure a relevant strategy for the whole vehicle, the safety of the battery, and the experience feelings of drivers and passengers.

When performing an estimation on the SOC, an ampere-hour integral algorithm is the main algorithm in a dynamic process of the battery. In the related art, a capacity value obtained from a capacity-temperature table is used as the available capacity value of the battery to perform ampere-hour integral calculation according to the current temperature of the battery pack. However, if the capacity-temperature table is inaccurate, a queried available capacity value is inaccurate, and the accuracy of the SOC is influenced accordingly.

CN 110 673 040 A discloses a method for estimating the SOC of an electric vehicle power battery, which includes the following steps: When the power battery is being charged or discharged, the state of charge of the power battery at the initial moment is obtained; the capacity change of the power battery is calculated from the initial moment to the current moment; the actual maximum capacity of the power battery calculated under the previous full charge or discharge is used as the maximum capacity of the power battery; the SOC of the power battery at the current time is obtained according to the state of charge, capacity change, and maximum capacity of the power battery at the initial time; the state of charge at the current time is: SOCend = SOCini + $\Delta$Q / Qmax, wherein SOCend is the state of charge at the current time, SOCini is the state of charge at the initial time, $\Delta$Q is the capacity change amount, and Qmax is the maximum capacity.

SUMMARY

TECHNICAL PROBLEM

It is an object of the present invention to provide a method for estimating an SOC of a battery, and a related device, a computer-readable storage medium, and a vehicle comprising the device, which aim at solving a problem that the estimation of the SOC of the battery is inaccurate.

TECHNICAL SOLUTIONS

The object is achieved with features of independent claim 1 regarding the method, with the features of independent claim 6 regarding the device. Independent claim 7 provides the computer-readable storage medium and independent claim 8 provides the vehicle. Further embodiments are defined in the respective dependent claims.

BENEFICIAL EFFECTS

In accordance with the method for estimating the SOC of the battery provided by the present invention, first, the maximum available capacity corresponding to at least one complete charging and discharging period of the battery before the current moment is obtained, and the historical maximum available capacity of the battery is calculated according to the maximum available capacities corresponding to various complete charging and discharging periods. Then, the current maximum available capacity of the battery is obtained, and the difference value between the historical maximum available capacity and the current maximum available capacity is obtained, the historical maximum available capacity is taken as the target capacity if the difference value is greater than the preset difference value threshold, otherwise, the current maximum available capacity is taken as the target capacity. Finally, the target capacity is taken as an available capacity of the battery at the current moment, and the ampere-hour integral calculation is performed to obtain the estimation value of the SOC of the battery at the current moment. According to the aforementioned solutions, in this embodiment, when the current maximum available capacity of the battery which is determined using the existing technologies has lower accuracy, historical data is used to calculate the historical maximum available capacity, and the difference value between the historical maximum available capacity and the current maximum available capacity obtained by table lookup is used to determine the target capacity. Thus, the accuracy of calculation of the SOC is improved.

DESCRIPTION OF THE DRAWINGS

In order to describe the embodiments of the present invention more clearly, a brief introduction regarding the accompanying drawings that need to be used for describing the embodiments of the present invention or the existing technologies is given below.

FIG. 1 is a flowchart illustrating an implementation of a method for estimating an SOC of a battery;
FIG. 2 is a schematic structural diagram of an apparatus for estimating an SOC of a battery;
FIG. 3 is a schematic diagram of an electronic device.

## DETAILED DESCRIPTION OF EMBODIMENTS

In the following descriptions, in order to describe but not intended to limit the present invention defined in the claims, concrete details including specific system structure and technique are proposed to facilitate a comprehensive understanding of the embodiments of the present invention. In other conditions, detailed explanations of method, circuit, device and system well known to the public are omitted, and thus unnecessary details which disturb the description of the present invention are avoided.

In order to make the objective, the technical solutions, and the advantages of the present invention be clearer, the present invention is described below with reference to the embodiments, and in combination with the accompanying drawings.

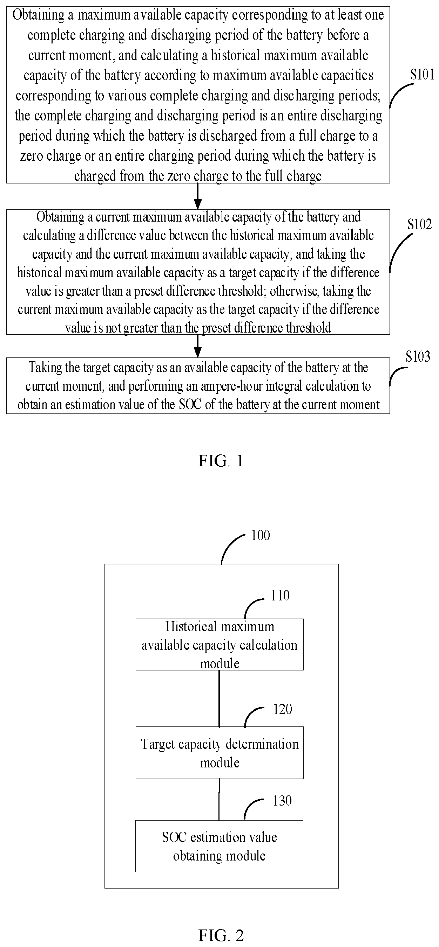

Referring to FIG. 1, FIG. 1 is a flowchart illustrating an implementation of a method for estimating a state of charge (SOC) of a battery according to one embodiment of the present invention.

In a step of S101, a maximum available capacity corresponding to at least one complete charging and discharging period of the battery before a current moment is obtained, and a historical maximum available capacity of the battery is calculated according to the maximum available capacities corresponding to various complete charging and discharging periods. The complete charging and discharging period is an entire discharging period during which the battery is discharged from a fully charged battery to a zero charge or an entire charging period during which the battery is charged from the zero charge to the full charge.

An execution subject (the electronic device) of this embodiment may be a battery management system (Battery Management System).

In this embodiment, the complete charging and discharging period refers to an entire period during which the battery is dropped from a fully charged state until the battery is in a disabled state and has zero charge, or an entire period during which the battery starts to be charged when it is in the disabled state with zero charge until the battery is fully charged. Taking the discharging period as an example, the maximum available capacity corresponding to the complete charging and discharging period indicates recording the accumulated ampere-hour value in the discharging process starting from the full-power state of the battery, until the battery is in the disabled state and has zero charge, and recording the accumulated ampere-hour value at this moment as the maximum available capacity in the complete charging and discharging period.

In a possible implementation manner, a specific implementation process of the step S101 includes: the maximum available capacity corresponding to the first N complete charging and discharging periods closest to the current moment of the battery is obtained, where $N \geq 1$ and N is an integer.

In this embodiment, in order to improve the accuracy of the historical maximum available capacity, in this embodiment, the maximum available capacities of the first N complete charging and discharging periods closest to the current moment are selected to calculate the historical maximum available capacity.

In one possible implementation manner, the specific implementation process of the step S101 further includes:
the maximum available capacities corresponding to various complete charging and discharging periods are averaged to obtain the historical maximum available capacity of the battery.

Furthermore, in order to improve the accuracy of the historical maximum available capacity of the battery, in this embodiment, a formula may be used to calculate the historical maximum available capacity of the battery, this formula is expressed as:

$$\begin{cases} Q_d = a \cdot Q_{T-1} + b \cdot Q_{T-2} \cdots + n \cdot Q_{T-N} \\ a + b + \cdots + n = 1 \end{cases}$$

and $a > b > \cdots > n$. Where, $Q_d$ represents the maximum available capacity of the battery, $Q_{T-1}$ represents the maximum available capacity corresponding to the first complete charging and discharging period closest to the current moment, $Q_{T-2}$ represents the maximum available capacity corresponding to the second complete charging and discharging period closest to the current moment, $Q_{T-N}$ represents the maximum available capacity corresponding to the first N-th complete charging and discharging period closest to the current moment, a, b, ..., n represent weights of $Q_{T-1}$, $Q_{T-2}$, $\cdots$, $Q_{T-N}$, respectively. That is, the closer the complete charging and discharging period approaches the current moment, the greater the weight of the maximum available capacity of the complete charging and discharging period, the further away the complete charging and discharging period is away from the current moment, the smaller the weight of the maximum available capacity of the complete charging and discharging period.

The historical maximum available capacity calculated through the abovementioned formula approximates the real value at the current moment, thereby improving the accuracy of the historical maximum available capacity.

For example, N may be 10.

In a step of S102, the current maximum available capacity of the battery is obtained; and a difference value between the historical maximum available capacity and the current maximum available capacity is calculated. If the difference value is greater than a preset difference threshold, the historical maximum available capacity is taken as the target capacity; if the difference value is not greater than the preset difference threshold, the current maximum available capacity is taken as the target capacity.

In this embodiment, an electronic device obtains the maximum available capacity (the current maximum available capacity) of the battery at the current moment through a table lookup method. When the difference value between the historical maximum available capacity and the current maximum available capacity obtained by the table lookup method is greater, the calculated historical maximum available capacity is more reliable, and the current maximum available capacity obtained by the table lookup method is corrected using the historical maximum available capacity. If the difference value is small, that is, the difference value is not greater than the preset difference threshold, the current maximum available capacity is not corrected, and the current maximum available capacity obtained by the table lookup method is directly used as the target capacity.

In one possible implementation manner, the step S102 specifically includes:

in a step of S201, a current temperature of a battery is obtained;
in a step of S202, the current maximum available capacity corresponding to the battery at the current temperature is obtained by looking up a preset capacity-temperature table.

In one possible implementation manner, after the step S202, the specific implementation process of the step S102 further includes:
the current maximum available capacity is multiplied by a health degree of the battery at the current moment to obtain an updated current maximum available capacity.

In this embodiment, the preset capacity-temperature table is a table including capacities, temperatures, and correspondence relationships therebetween. Since the actual situation is usually not completely consistent with the experimental scene before delivery, the maximum available capacity obtained based on table lookup sometimes has a certain error.

In this embodiment, the health degree is the health state of the battery, and indicates the ratio of the actual maximum available capacity to the rated capacity of the new battery in a certain operating environment.

In a step of S103, the target capacity is taken as the available capacity of the battery at the current moment, and ampere-hour integral calculation is performed to obtain the estimation value of the SOC of the battery at the current moment.

The ampere-hour integral algorithm is used to calculate the remaining available capacity of the battery in a dynamic process, the advantage of the ampere-hour integral algorithm is that the battery has relatively smaller limitation on the ampere-hour integral algorithm, this calculation method is simple and reliable, and the SOC of the battery can be estimated in real time.

Specifically, the formula of the ampere-hour integral algorithm for calculating the remaining available capacity is expressed as:

$$C_t = C_{t-1} + \int_{t-1}^{t} i * dt \ ,$$

where $C_t$ represents the remaining available capacity of the battery at a moment t, $C_{t-1}$ represents the remaining available capacity of the battery at a moment t-1, i represents charging and discharging current of the battery at the moment t. Where, i represents a charging current when it is positive, i represents a discharging current when it is negative, t represents the current moment, and t-1 represents a previous moment of the current moment.

After the remaining available capacity at the current moment is obtained through calculation, the estimation value of the SOC of the battery at the current moment is obtained according to the formula expressed as $SOC_t = \dfrac{C_t}{C_0} \times 100\%$ , where $SOC_t$ represents the estimation value of the SOC at the moment t, $C_t$ represents the remaining available capacity at the moment t, and $C_0$ represents the available capacity of the battery at the moment t.

The specific implementation process of the step S103 further includes:
the estimation value of the SOC of the battery at the current moment is obtained through a formula expressed as $SOC_t = SOC_{t-1} + \dfrac{\int_{t-1}^{t} idt}{C_0}$ .

Where, $SOC_t$ represents the estimation value of the SOC of the battery at the moment t, $SOC_{t-1}$ represents the estimation value of the SOC of the battery at the moment t-1, i represents the current value of the battery at the moment t, and $C_0$ represents the available capacity of the battery at the moment T.

It can be seen from the aforementioned embodiments that, a method for estimating the SOC of the battery is provided in the embodiments of the present invention. First, the current value of the battery at the current moment is obtained. Then, the maximum available capacity corresponding to at least one complete charging and discharging period of the battery before the current moment is obtained, and the historical maximum available capacity of the battery is calculated according to the maximum available capacities corresponding to various complete charging and discharging periods. Then, the current maximum available capacity of the battery is obtained, and the difference value between the historical maximum available capacity and the current maximum available capacity is obtained, the historical maximum available capacity is taken as the target capacity if the difference value is greater than the preset difference value threshold, otherwise, the current maximum available capacity is taken as the target capacity. Finally, the target capacity is taken as an available capacity of the battery at the current moment, and the ampere-hour integral calculation is performed to obtain the estimation value of the SOC of the battery at the current moment. In this embodiment, when the current maximum available capacity of the battery which is determined using the existing technologies has lower accuracy, historical data is used to calculate the historical maximum available capacity, and the difference value between the historical maximum available capacity and the current maximum available capacity obtained by table lookup is used to determine the target capacity. Thus, the accuracy of calculation of the SOC is improved.

It should be understood that, the values of serial numbers of the steps in the aforesaid embodiments do not indicate an order of execution sequences of the steps; instead, the execution sequences of the steps should be determined by functionalities and internal logic of the steps, and thus shouldn't be regarded as limitation to implementation processes of the embodiments of the present invention.

A corresponding apparatus is described below. Regarding the details that are not described in detail, reference can be made to the corresponding method embodiments described above.

FIG. 2 illustrates a schematic structural diagram of an apparatus for estimating an SOC of a battery. The apparatus is described in detail below.

An apparatus for estimating an SOC of a battery, includes:

a historical maximum available capacity calculation module 110 configured to obtain a maximum available capacity corresponding to at least one complete charging and discharging period of the battery before a current moment, and calculate a historical maximum available capacity of the battery according to maximum available capacities corresponding to various complete charging and discharging periods; the complete charging and discharging period is an entire discharging period during which the battery is discharged from a full charge to a zero charge or an entire charging period during which the battery is charged from the zero charge to the full charge; a target capacity determination module 120 configured to obtain a current maximum available capacity of the battery and calculate a difference value between the historical maximum available capacity and the current maximum available capacity, and take the historical maximum available capacity as a target capacity if the difference value is greater than a preset difference threshold, or take the current maximum available capacity as the target capacity if the difference value is not greater than the preset difference threshold;
an SOC estimation value obtaining module 130 configured to take the target capacity as an available capacity of the battery at the current moment, and perform an ampere-hour integral calculation to obtain an estimation value of the SOC of the battery at the current moment.

In one possible implementation manner, the historical maximum available capacity calculation module 110 includes:
a maximum available capacity obtaining unit configured to obtain the maximum available capacity corresponding to the first N complete charging and discharging periods of the battery closest to the current moment, where N≥1 and N is an integer.

In one possible implementation manner, the historical maximum available capacity calculation module 110 further includes:
a historical maximum available capacity calculation unit configured to perform an average calculation on the maximum available capacities corresponding to the various complete charging and discharging periods to obtain the historical maximum available capacity of the battery.

In one possible implementation manner, the target capacity determination module includes a current maximum available capacity obtaining unit configured to:

obtain a current temperature of the battery;
query a corresponding current maximum available capacity of the battery at the current temperature according to a preset capacity-temperature table.

In one possible implementation manner, the current maximum available capacity obtaining unit is further configured to:
obtain an updated current maximum available capacity by multiplying the current maximum available capacity with a health degree of the battery at the current moment.

In one possible implementation manner, the SOC estimation value obtaining module 130 is specifically configured to:

obtain the estimation value of the SOC of the battery at the current moment through a formula expressed as:

$$SOC_t = SOC_{t-1} + \frac{\int_{t-1}^{t} i\,dt}{C_o}$$

where, $SOC_t$ represents the estimation value of the SOC at a moment t, $SOC_{t-1}$ represents the estimation value of the SOC at a moment t-1, i represents a current value of the battery at the moment t, and $C_o$ represents the available capacity of the battery at the moment t.

It can be seen from the aforementioned embodiment that, in this embodiment, the estimation value of the SOC may be calculated by considering multidimensional factors such as a historical maximum available capacity value, a capacity-temperature table, and the battery health degree (SOH) in the charging and discharging operation process of the battery, and the problem that the introduction of SOC error, which is caused due to improper capacity selection, enables the estimation of the SOC to be inaccurate and thereby influencing the accuracy of the SOC is avoided.

A computer program product is further provided by the present invention. The computer program product has program codes, that, when executed on a corresponding processor, a controller, a computing device, or an electronic device, performs the steps in any one of the method embodiments for estimating the SOC of the battery, such as the steps S101 to S103 shown in FIG. 1. A person of ordinary skill in the art should understand that the method proposed in the embodiments of the present invention may be implemented in various forms of hardware, software, firmware, an application specific processor, or a combination thereof. The application specific processor may include an application specific integrated circuit (ASIC), a reduced instruction set computer (RISC), and/or a field programmable gate array (FPGA). The proposed method and apparatus are preferably implemented as a combination of hardware and software. The software is preferably an application program installed on a program storage device, which is typically a machine based on a computer platform with hardware, such as one or a plurality of central processing units (CPUs), random access memory (RAM), and one or a plurality of input/output (I/O) interfaces. An operating system is also installed on the computer platform typically. The various processes and functions described herein may be a part of the application program, or alternatively, a part of the various processes and functions may be executed by the operating system.

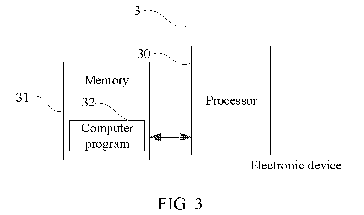

FIG. 3 is a schematic diagram of an electronic device according to one embodiment of the present invention. As shown in FIG. 3, the electronic device 3 in this embodiment includes: a processor 30, a memory 31, and a computer program 32 stored in the memory 31 and executable by the processor 30. The processor 30 is configured to, when executing the computer program 32, implement the steps (e.g., the steps 101 to 103 shown in FIG. 1) in the various method embodiments for estimating the SOC of the battery. As an alternative, the processor 30 is configure to, when executing the computer program 32, implement the functions (e.g., the functions of the module 110, the module 120 and the module 130 shown in FIG. 2) of the various modules/units in the apparatus embodiments.

Exemplarily, the computer program 32 may be divided into one or a plurality of modules/units, the one or plurality of modules/units are stored in the memory 31, and executed by the processor 30 so as to accomplish/implement the technical solutions proposed in the present invention. The one or plurality of modules/units may be a series of computer program instruction segments that can accomplish particular functionalities, these instruction segments are used for describing an executive process of the computer program 32 in the electronic device 3. For example, the computer program 32 may be divided into the module 110, the module 120 and the module 130 shown in FIG. 2.

The electronic device 3 may include but is not limited to the processor 30, the memory 31. The person of ordinary skill in the art may understand that, FIG. 3 is only one example of the electronic device 3, and thus should not be constituted as limitation to the electronic device 3. More or less components than the components shown in FIG. 3 may be included, as an alternative, some components or different components may be combined, For example, the electronic device 3 may also include an input and output device, a network access device, a bus, etc.

The so-called processor 30 may be central processing unit (CPU), and can also be other general purpose processor, digital signal processor (DSP), application specific integrated circuit (ASIC), field-programmable gate array (FGPA), or some other programmable logic devices, discrete gate or transistor logic device, discrete hardware component, etc. The general purpose processor may be a microprocessor, as an alternative, the processor may also be any conventional processor, or the like.

The memory 31 may be an internal storage unit of the electronic device 3, such as a hard disk or a memory of the electronic device 3. The memory 31 may also be an external storage device of the electronic device 3, such as a plug-in hard disk, a smart media card (Smart Media Card, SMC), a secure digital (Secure Digital, SD) card, a flash card (Flash Card, FC) equipped on the electronic device 3. Furthermore, the memory 31 may not only include the internal storage unit of the electronic device 3, but also include the external memory of the electronic device 3. The memory 31 is configured to store the computer program, and other procedures and data as required by the electronic device 3. The memory 31 may also be configured to store data that has been output or being ready to be output temporarily.

A vehicle is further provided in this embodiment. The vehicle includes the aforementioned electronic device.

The person of ordinary skill in the art may clearly understand that, for the convenience of description and for conciseness, the dividing of the various functional units and functional modules is merely described according to examples. In an actual application, these functions may be assigned to different functional units and functional modules to be accomplished, that is, an inner structure of the device is divided into different functional units or modules to accomplish the whole or some of functionalities described above. The various functional units and modules in the embodiments may be integrated into a processing unit, or each of the units exists independently and physically, or two or more than two of the units are integrated into a single unit. The aforementioned integrated unit may either by actualized in the form of hardware or in the form of software functional units. In addition, specific names of the various functional units and modules are only used to be distinguished from each other conveniently, rather than being intended to limit the protection scope of the present invention. Regarding the specific operating process of the units and modules in the aforementioned system, reference may be made to a corresponding process in the aforementioned method embodiments. This specific operating process of the units and modules is not repeatedly described herein.

In the aforesaid embodiments, the descriptions of the various embodiments are emphasized respectively, regarding a part of one embodiment which has not been described or disclosed in detail, reference can be made to relevant descriptions in other embodiments.

The person of ordinary skill in the art may understand that, the elements and algorithm steps of each of the examples described in connection with the embodiments disclosed herein may be implemented in electronic hardware, or in combination with computer software and electronic hardware. Whether these functions are implemented by hardware or software depends on the specific application and design constraints of the technical solution. The skilled people could use different methods to implement the described functions for each particular application, however, such implementations should not be considered as going beyond the scope of the present invention.

It should be understood that, in the embodiments of the present invention, the disclosed device/electronic device and method could be implemented in other ways. For example, the aforementioned apparatus/electronic device embodiments are merely illustrative. For example, the division of the units is only a logical function division, and other division could be used in the actual implementation. For example, multiple units or components could be combined or integrated into another system, or some features may be ignored, or not performed. In another aspect, the coupling or direct coupling or communicating connection shown or discussed could be an indirect coupling or a communicating connection through some interfaces, devices or units, and the coupling or direct coupling or communicating connection could be electrical, mechanical, or in other form.

The units described as separate components can be or cannot be physically separate, the components shown as units can be or cannot be physical units, the components may be located in one place, or be distributed onto multiple network elements. A part or a whole of the elements can be selected to achieve the objective of the technical solution of this embodiment according to the actual requirement.

In addition, the various functional units in each of the embodiments of the present invention may be integrated into a single processing unit, or exist individually and physically, or two or more than two units are integrated into a single unit. The aforesaid integrated unit can either be achieved by hardware, or be achieved in the form of software functional units.

When the integrated unit is achieved in the form of software functional units, and is sold or used as an independent product, the integrated unit may be stored in a computer readable storage medium. Based on this understanding, a whole or part of flow process for implementing the method in the embodiments of the present invention can also be accomplished in the manner of using computer program to instruct relevant hardware. When the computer program is executed by the processor, the steps in the various method embodiments described above may be implemented. Wherein, the computer program comprises computer program codes, which may be in the form of source code, object code, executable documents or some intermediate form, etc. The computer readable medium can include: any physical equipment or device that can carry the computer program codes, recording medium, USB flash disk, mobile hard disk, hard disk, optical disk, computer memory, ROM (Read-Only Memory), RAM (Random Access Memory), electrical carrier signal, telecommunication signal and software distribution medium, etc. It needs to be explained that, the contents contained in the computer readable medium may be added or reduced appropriately according to the requirement of legislation and patent practice in a judicial district, for example, in some judicial districts, according to legislation and patent practice, the computer readable medium doesn't include electrical carrier signal and telecommunication signal.

**Claims**

1. A method for estimating an SOC of a battery, the method comprising:

   a step (S101) of obtaining a maximum available capacity corresponding to at least one complete charging and discharging period of the battery before a current moment, and calculating a historical maximum available capacity of the battery according to maximum available capacities corresponding to various complete charging and discharging periods, wherein the complete charging and discharging period is an entire discharging period during which the battery is discharged from a full charge to a zero charge or an entire charging period during which the battery is charged from the zero charge to the full charge;
   a step (S102) of obtaining a current maximum available capacity of the battery and calculating a difference value between the historical maximum available capacity and the current maximum available capacity, and taking the historical maximum available capacity as a target capacity if the difference value is greater than a preset difference threshold; or alternatively, taking the current maximum available capacity as the target capacity if the difference value is not greater than the preset difference threshold; and
a step (S103) of taking the target capacity as an available capacity of the battery at the current moment, and performing an ampere-hour integral calculation to obtain an estimation value of the SOC of the battery at the current moment, wherein,
the estimation value of the SOC of the battery at the current moment is obtained through the formula expressed as:

$$SOC_t = SOC_{t-1} + \frac{\int_{t-1}^{t} i\, dt}{C_o}$$

wherein, $SOC_t$ represents the estimation value of the SOC at a moment t, $SOC_{t-1}$ represents the estimation value of the SOC at a moment t-1, i represents a current value of the battery at the moment t, and $C_o$ represents an available capacity of the battery at the moment t.

2. The method for estimating the SOC of the battery according to claim 1, wherein the step of obtaining the maximum available capacity corresponding to the at least one complete charging and discharging period of the battery before the current moment comprises:
obtaining the maximum available capacities corresponding to first N complete charging and discharging periods of the battery closest to the current moment, wherein, $N \geq 1$ and N is an integer.

3. The method for estimating the SOC of the battery according to claim 1, wherein the step of calculating the historical maximum available capacity of the battery according to the maximum available capacities corresponding to the various complete charging and discharging period comprises:
performing an average calculation on the maximum available capacities corresponding to the various complete charging and discharging periods to obtain the historical maximum available capacity of the battery.

4. The method for estimating the SOC of the battery according to claim 1, wherein the step of obtaining the current maximum available capacity of the battery comprises:

acquiring a current temperature of the battery; querying the current maximum available capacity corresponding to the battery at the current temperature according to a preset capacity-temperature table.

5. The method for estimating the SOC of the battery according to claim 4, wherein after the step of querying the current maximum available capacity corresponding to the battery at the current temperature according to the preset capacity-temperature table, the method further comprises:
obtaining an updated current maximum available capacity by multiplying the current maximum available capacity with a health degree of the battery at the current moment.

6. An electronic device (3), comprising a memory (31), a processor (30) and a computer program (32) stored in the memory (31) and executable by the processor (30), wherein the processor (30) is configured to, when executing the computer program (32), implement the steps of the method for estimating the SOC of the battery according to any one of claims 1-5.

7. A computer-readable storage medium, which stores a computer program (32), wherein the computer program (32) is configured to, when executed by a processor (30), implement steps of the method for estimating the SOC of the battery according to any one of claims 1 to 5.

8. A vehicle, comprising the electronic device (3) according to claim 6.

**Patentansprüche**

1. Verfahren zum Schätzen eines SOC einer Batterie, wobei das Verfahren aufweist:

einen Schritt (S101) des Erhaltens einer maximalen verfügbaren Kapazität entsprechend zumindest einer vollständigen Lade- und Entladeperiode der Batterie vor einem aktuellen Zeitpunkt, und des Berechnens einer historischen maximalen verfügbaren Kapazität der Batterie gemäß maximalen verfügbaren Kapazitäten entsprechend verschiedenen vollständigen Lade- und Entladeperioden, wobei die vollständige Lade- und Entladeperiode eine gesamte Entladeperiode ist, während der die Batterie von einer Vollladung auf eine Nullladung entladen wird, oder eine gesamte Ladeperiode ist, während der die Batterie von der Nullladung auf die Vollladung geladen wird;
einen Schritt (S102) des Erhaltens einer aktuellen maximalen verfügbaren Kapazität der Batterie und des Berechnens eines Differenzwerts zwischen der historischen maximalen verfügbaren Kapazität und der aktuellen maximalen verfügbaren Kapazität, und des Annehmens der historischen maximalen verfügbaren Kapazität als eine Zielkapazität, wenn der Differenzwert größer als ein vorgegebener Differenzschwellwert ist; oder alternativ des Annehmens der aktuellen maximalen verfügbaren Kapazität als die Zielkapazität, wenn der Differenzwert nicht größer als der vorgegebene Differenzschwellwert ist; und
einen Schritt (S103) des Annehmens der Zielkapazität als eine verfügbare Kapazität der Batterie zu dem aktuellen Zeitpunkt, und des Durchführens einer Amperestunden-Integralberechnung, um einen Schätzwert des SOC der Batterie zu dem aktuellen Zeitpunkt zu erhalten, wobei
der Schätzwert des SOC der Batterie zu dem aktuellen Zeitpunkt durch die wie folgt ausgedrückte Formel erhalten wird:

$$SOC_t = SOC_{t-1} + \frac{\int_{t-1}^{t} i\,dt}{C_0}$$

wobei $SOC_t$ den Schätzwert des SOC zu einem Zeitpunkt t darstellt, $SOC_{t-1}$ den Schätzwert des SOC zu einem Zeitpunkt t-1 darstellt, i einen Stromwert der Batterie zu dem Zeitpunkt t darstellt, und $C_0$ eine verfügbare Kapazität der Batterie zu dem Zeitpunkt t darstellt.

2. Verfahren zum Schätzen des SOC der Batterie nach Anspruch 1, wobei der Schritt des Erhaltens der maximalen verfügbaren Kapazität entsprechend der zumindest einen vollständigen Lade- und Entladeperiode der Batterie vor dem aktuellen Zeitpunkt aufweist:
Erhalten der maximalen verfügbaren Kapazitäten entsprechend ersten N vollständigen Lade- und Entladeperioden der Batterie, die dem aktuellen Zeitpunkt am nächsten liegen, wobei N≥1 und N eine ganze Zahl ist.

3. Verfahren zum Schätzen des SOC der Batterie nach Anspruch 1, wobei der Schritt des Berechnens der historischen maximalen verfügbaren Kapazität der Batterie gemäß den maximalen verfügbaren Kapazitäten entsprechend den verschiedenen vollständigen Lade- und Entladeperioden aufweist:
Durchführen einer Mittelwertberechnung über die maximalen verfügbaren Kapazitäten entsprechend den verschiedenen vollständigen Lade- und Entladeperioden, um die historische maximale verfügbare Kapazität der Batterie zu erhalten.

4. Verfahren zum Schätzen des SOC der Batterie nach Anspruch 1, wobei der Schritt des Erhaltens der aktuellen maximalen verfügbaren Kapazität der Batterie aufweist:

Erfassen einer aktuellen Temperatur der Batterie;
Abfragen der aktuellen maximalen verfügbaren Kapazität entsprechend der Batterie bei der aktuellen Temperatur gemäß einer vorgegebenen Kapazität-Temperatur-Tabelle.

5. Verfahren zum Schätzen des SOC der Batterie nach Anspruch 4, wobei das Verfahren nach dem Schritt des Abfragens der aktuellen maximalen verfügbaren Kapazität entsprechend der Batterie bei der aktuellen Temperatur gemäß der vorgegebenen Kapazität-Temperatur-Tabelle ferner aufweist:
Erhalten einer aktualisierten aktuellen maximalen verfügbaren Kapazität durch Multiplizieren der aktuellen maximalen verfügbaren Kapazität mit einem Gesundheitsgrad der Batterie zu dem aktuellen Zeitpunkt.

6. Elektronische Vorrichtung (3), aufweisend einen Speicher (31), einen Prozessor (30) und ein in dem Speicher (31) gespeichertes und durch den Prozessor (30) ausführbares Computerprogramm (32), wobei der Prozessor (30) dazu konfiguriert ist, beim Ausführen des Computerprogramms (32) die Schritte des Verfahrens zum Schätzen des SOC der Batterie nach einem der Ansprüche 1-5 zu implementieren.

7. Computerlesbares Speichermedium, welches ein Computerprogramm (32) speichert, wobei das Computerprogramm (32) dazu konfiguriert ist, bei Ausführung durch einen Prozessor (30) Schritte des Verfahrens zum Schätzen des SOC der Batterie nach einem der Ansprüche 1 bis 5 zu implementieren.

8. Fahrzeug, mit der elektronischen Vorrichtung (3) nach Anspruch 6.

**Revendications**

1. Procédé pour estimer un SOC d'une batterie, le procédé comprenant :

une étape (S101) d'obtention d'une capacité disponible maximum qui correspond à au moins une période complète de charge et de décharge de la batterie avant un instant courant, et de calcul d'une capacité disponible maximum historique de la batterie conformément à des capacités disponibles maximum qui correspondent à diverses périodes complètes de charge et de décharge, dans lequel la période complète de charge et de décharge est la totalité d'une période de décharge pendant laquelle la batterie est déchargée depuis une pleine charge jusqu'à une charge de zéro ou la totalité d'une période de charge pendant laquelle la batterie est chargée depuis la charge de zéro jusqu'à la pleine charge ;

une étape (S102) d'obtention d'une capacité disponible maximum courante de la batterie et de calcul d'une valeur de différence entre la capacité disponible maximum historique et la capacité disponible maximum courante, et de considération de la capacité disponible maximum historique en tant que capacité cible si la valeur de différence est supérieure à un seuil de différence prédéfini ; ou à titre d'alternative, de considération de la capacité disponible maximum courante en tant que capacité cible si la valeur de différence n'est pas supérieure au seuil de différence prédéfini ; et

une étape (S103) de considération de la capacité cible en tant que capacité disponible de la batterie à l'instant courant, et de réalisation d'un calcul d'intégrale en ampères-heures pour obtenir une valeur d'estimation du SOC de la batterie à l'instant courant, dans lequel :

la valeur d'estimation du SOC de la batterie à l'instant courant est obtenue par l'intermédiaire de la formule exprimée comme suit :

$$SOC_t = SOC_{t-1} + \frac{\int_{t-1}^{t} i\,dt}{C_0}$$

dans laquelle $SOC_t$ représente la valeur d'estimation du SOC à un instant $t$, $SOC_{t-1}$ représente la valeur d'estimation du SOC à un instant $t-1$, $i$ représente une valeur de courant de la batterie à l'instant $t$ et $C_0$ représente une capacité disponible de la batterie à l'instant $t$.

2. Procédé pour estimer le SOC de la batterie selon la revendication 1, dans lequel l'étape d'obtention de la capacité disponible maximum qui correspond à l'au moins une période complète de charge et de décharge de la batterie avant l'instant courant comprend :
l'obtention des capacités disponibles maximum qui correspondent à N premières périodes complètes de charge et de décharge de la batterie les plus proches de l'instant courant, où N ≥ 1 et N est un entier.

3. Procédé pour estimer le SOC de la batterie selon la revendication 1, dans lequel l'étape de calcul de la capacité disponible maximum historique de la batterie conformément aux capacités disponibles maximum qui correspondent aux diverses périodes complètes de charge et de décharge comprend :
la réalisation d'un calcul de moyenne sur les capacités disponibles maximum qui correspondent aux diverses périodes complètes de charge et de décharge pour obtenir la capacité disponible maximum historique de la batterie.

4. Procédé pour estimer le SOC de la batterie selon la revendication 1, dans lequel l'étape d'obtention de la capacité disponible maximum courante de la batterie comprend :

l'acquisition d'une température courante de la batterie ; et
la recherche de la capacité disponible maximum courante qui correspond à la batterie à la température courante conformément à une table capacité-température prédéfinie.

5. Procédé pour estimer le SOC de la batterie selon la revendication 4, dans lequel, après l'étape de recherche de la capacité disponible maximum courante qui correspond à la batterie à la température courante conformément à la table capacité-température prédéfinie, le procédé comprend en outre :
l'obtention d'une capacité disponible maximum courante mise à jour en multipliant la capacité disponible maximum courante par un degré de santé de la batterie à l'instant courant.

6. Dispositif électronique (3), comprenant une mémoire (31), un processeur (30) et un programme informatique (32) qui est stocké dans la mémoire (31) et qui peut être exécuté par le processeur (30), dans lequel le processeur (30) est configuré pour, lors de l'exécution du programme informatique (32), mettre en œuvre les étapes du procédé pour estimer le SOC de la batterie selon l'une quelconque des revendications 1 à 5.

7. Support de stockage lisible par ordinateur, lequel stocke un programme informatique (32), dans lequel le programme informatique (32) est configuré pour, lorsqu'il est exécuté par un processeur (30), mettre en œuvre des étapes du procédé pour estimer le SOC de la batterie selon l'une quelconque des revendications 1 à 5.

8. Véhicule, comprenant le dispositif électronique (3) selon la revendication 6.

Obtaining a maximum available capacity corresponding to at least one complete charging and discharging period of the battery before a current moment, and calculating a historical maximum available capacity of the battery according to maximum available capacities corresponding to various complete charging and discharging periods; the complete charging and discharging period is an entire discharging period during which the battery is discharged from a full charge to a zero charge or an entire charging period during which the battery is charged from the zero charge to the full charge

S101

Obtaining a current maximum available capacity of the battery and calculating a difference value between the historical maximum available capacity and the current maximum available capacity, and taking the historical maximum available capacity as a target capacity if the difference value is greater than a preset difference threshold; otherwise, taking the current maximum available capacity as the target capacity if the difference value is not greater than the preset difference threshold

S102

Taking the target capacity as an available capacity of the battery at the current moment, and performing an ampere-hour integral calculation to obtain an estimation value of the SOC of the battery at the current moment

S103

FIG. 1

100

110

Historical maximum available capacity calculation module

120

Target capacity determination module

130

SOC estimation value obtaining module

FIG. 2

3

30

Memory

31

32

Processor

Computer
program

Electronic device

FIG. 3

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 110673040 A